# EUROPEAN PATENT APPLICATION

(11) **EP 4 129 495 A1**
(43) Date of publication of application: **08.02.2023**
(21) Application number: 21780572.0
(22) Date of filing: 25.03.2021
(51) Int. Cl.: B05D 3/00, B05D 3/12, B05D 7/00, B05D 7/24, H01G 4/30

(54) **METHOD FOR MANUFACTURING ELECTRONIC COMPONENT**

(30) Priority: 02.04.2020 JP 2020066738
(71) Applicant: Creative Coatings Co., Ltd., Shinjuku-ku Tokyo 162-0842 (JP)
(72) Inventor: SATO, Eiji, Tokyo 162-0842 (JP); SAKAMOTO, Hitoshi, Tokyo 162-0842 (JP)
(74) Representative: Wunderlich & Heim Patentanwälte Partnerschaftsgesellschaft mbB
(86) International application number: PCT/JP2021/012603
(87) International publication number: WO 2021/200562

(57) **Abstract**

A pre-press process includes a first step for bonding a first end portion (12A) of each of a plurality of electronic component bodies (10) to a bonding surface on an exposed surface of a flat plate material (22) disposed in a jig (20), a second step for moving the jig (20) relative to a surface plate (30), a third step for bringing a second end portions (12B) on the opposite side to a first end portion (12A) of each of the plurality of electronic component bodies (10) into contact with the surface plate (30) while the flat plate material (22) is in a softened state so that the flat plate material (22) is deformed to align respective positions of end surfaces (12B1) of the second end portions (12B), a fourth step for curing the flat plate material (22) with the positions of the end surfaces (12B1) aligned with one another, and then a fifth step for moving the jig (20) relative to the surface plate (30) to separate from the surface plate (30) the plurality of electronic component bodies (10) in which the respective positions of the end surfaces (12B1) are aligned with one another.

## Description

### TECHNICAL FIELD

The present invention relates to an electronic component manufacturing method including a coating process for coating a plurality of electronic component bodies with a conductive paste and a pre-press process to be performed before the coating process.

### BACKGROUND ART

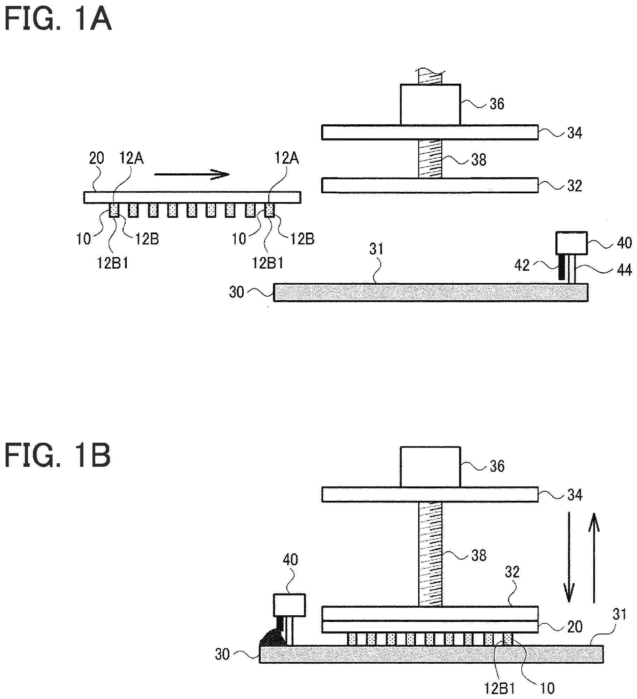

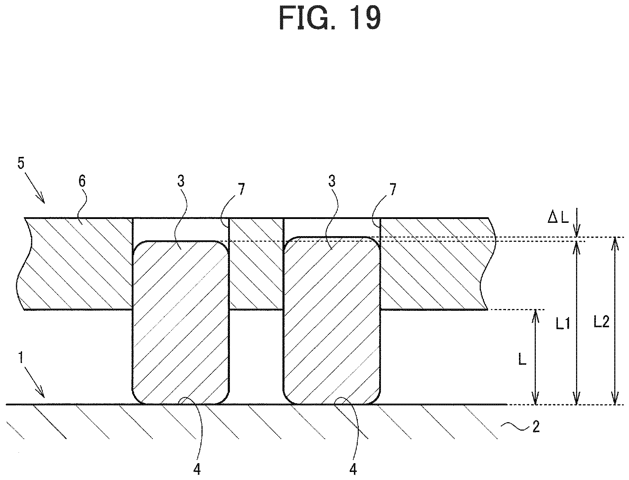

The present applicant has proposed an apparatus and method for manufacturing an electronic component by dip-coating an end surface of an electronic component body such as a multilayer ceramic capacitor, an inductor, or a thermistor with a conductive paste layer and forming an external electrode in the electronic component body (Patent Document 1). In FIG. 1B in Patent Document 1, a pre-press method is disclosed as a process preceding a coating process for dip-coating the end surface of the electronic component body with the conductive paste layer. As illustrated in FIG. 19, in the pre-press process, an electronic component body 3 is lowered with respect to a surface plate 2 having a conductive paste not laid over its main surface 1, to bring an end surface 4 of the electronic component body 3 into contact with the main surface 1 of the surface plate 2. Then, the electronic component body 3 is raised. A jig (carrier plate) 5 that holds a plurality of electronic component bodies 3 to be simultaneously pre-pressed has a through hole 7, into which the electronic component bodies 3 are fitted, in its jig body 6 made of rubber, for example. The plurality of electronic component bodes 3 respectively have different overall lengths L1 and L2, and there is a variation in an overall length difference ΔL thereamong. When the pre-press process is performed, a length L in which each of the plurality of electronic component bodies 3 protrudes from the through hole 7, i.e., a height L leading to each of the end surfaces 4 of the plurality of electronic component bodies 3 from the jig body 6 becomes uniform. This makes it possible to align respective positions of the end surfaces 4 of the plurality of electronic component bodies 3 with one another regardless of the existence of the overall length difference ΔL.

### RELATED-ART DOCUMENT

### PATENT DOCUMENT

Patent Document 1: JP-B-6633829

### SUMMARY OF THE INVENTION

### TECHNICAL PROBLEM

When the number of electronic component bodies 3 to be simultaneously subjected to batch processing increases, it is difficult to fit the electronic component bodies 3 into the hole 7 of the jig body 6 illustrated in FIG. 19. As another jig that holds the plurality of electronic component bodies 3, the electronic component bodies 3 may be bonded to and held in a bonding layer formed on a base material as a rigid body. However, even though the electronic component bodies 3 bonded to and held in the jig are pre-pressed with the respective end surfaces 4 thereof being in contact with the surface plate 2, the respective positions of the end surfaces 4 of the plurality of electronic component bodies 3 cannot be aligned with one another due to lack of the function of the hole 7 of the jig 5 illustrated in FIG. 19.

Some aspects of the present invention are directed to providing an electronic component manufacturing method capable of aligning respective positions of end surfaces of a plurality of electronic component bodies with one another while bonding and holding the plurality of electronic component bodies.

### SOLUTION TO PROBLEM

(1) In some aspects of the present invention, there is provided an electronic component manufacturing method comprising a coating process for coating each of a plurality of electronic component bodies with a paste and a pre-press process to be performed before the coating process, wherein
   the pre-press process comprises:
   a first step for bonding a first end portion of each of the plurality of electronic component bodies to a bonding surface on an exposed surface of a flat plate material disposed in a jig,
   a second step for moving the jig relative to a surface plate;
   a third step for bringing the flat plate material into a softened state and bringing a second end portion on the opposite side to the first end portion of each of the plurality of electronic component bodies into contact with the surface plate so that the flat plate material is deformed to align respective positions of end surfaces of the second end portions;
   a fourth step for bringing the flat plate material into a cured state with the respective positions of the end surfaces aligned with one another; and then
   a fifth step for moving the jig relative to the surface plate, and separating, from the surface plate, the plurality of electronic component bodies in which the positions of the end surfaces are aligned with one another.

   According to the aspect of the invention, when the flat plate material disposed in the jig is in the softened state, the respective positions of the end surfaces of the second end portions of the plurality of electronic component bodies to be brought into contact with the surface plate are aligned with one another, and the flat plate material is then cured. As a result, the plurality of electronic component bodies to be held in the jig by the bonding are held in the jig with the respective positions of the end surfaces of the second end portions aligned with one another. This makes it possible to align the respective positions of the end surfaces of the plurality of electronic component bodies with one another while bonding and holding the plurality of electronic component bodies. When the coating process is performed after the pre-press process, the respective film thicknesses of the pastes to be applied to the end surfaces of the plurality of electronic component bodies can be made uniform. As the flat plate material that changes into a softened phase and a cured phase, a thermoplastic resin (a thermoplastic adhesive), a thermosetting resin, a thermoplastic elastomer, a thermosetting elastomer, or the like can be used. Among the resins or the elastomers, particularly a shape memory resin, a stimulus responsive material (a gel, a resin, an elastomer, etc.) that can be softened and cured, or the like can be used.
(2) In accordance with one of some aspect, the electronic component manufacturing method according to the aspect (1), may further comprise
   a paste removal process for removing an excess paste from the paste applied to the second end portion of each of the plurality of electronic component bodies held in the jig to form a paste layer after the coating process.
   Addition of this process makes it possible to enhance uniformity in the respective film thicknesses of the pastes formed by being applied to the plurality of electronic component bodies.
(3) In accordance with one of some aspect, the electronic component manufacturing method according to the aspect (1) or (2), may further comprise
   a detachment process for detaching the plurality of electronic component bodies from the jig after the coating process or the paste removal process,
   wherein, in the detachment process, the flat plate material deformed in the third step and cured in the fourth step may be softened again to make the plurality of electronic component bodies detachable from the jig.

   This makes it possible to reduce a load when the plurality of electronic component bodies is detached from the jig. To reuse the flat plate material softened in the detachment process, the flat plate material can be formed into an original shape (e.g., a flat plate) used in the previous first step and cured, for example. When the flat plate material does not have a reversible phase of softening and curing, like the thermosetting resin, the flat plate material after the electronic component bodies are detached may be recycled without being reused. If the flat plate material is thus disposed, the flat plate material may be forcedly deformed to destroy the shape thereof. Therefore, it is not essential to soften the flat plate material again in the detachment process.
(4) In accordance with one of some aspect, the electronic component manufacturing method according to the aspect (1) or (2), may further comprise
   a detachment process for detaching the plurality of electronic component bodies from the jig after the coating process or the paste removal process,
   wherein, in the detachment process, the flat plate material deformed in the third step and cured in the fourth step may be deformed into a state where the plurality of electronic component bodies can be detached from the jig and a shape retained state other than the softened state and the cured state.

   This makes it possible to use the flat plate material after the detachment process again as it is.
(5) In accordance with one of some aspect, there is provided the electronic component manufacturing method according to the aspect (4), wherein
   the flat plate material may be a shape memory resin, the shape memory resin may be set to have a flat plate shape as a shape-memory primary shape in the first step, the second step, and the detachment process, and the shape memory resin may be set to have any secondary shape equal to the softened state or the cured state where the respective positions of the end surfaces of the second end portions are aligned with one another in the third step, the fourth step, and the fifth step.
   A shape memory state (the primary shape) of the shape memory resin can be effectively used as a shape retained state other than the softened state and the cured state (the secondary shape).
(6) In accordance with one of some aspect, there is provided the electronic component manufacturing method according to the aspect (5), wherein transition of the shape memory resin to the softened state may be started in the second step.
   As a result, the shape memory resin is deformed at the same time that the electronic component body contacts the surface plate, thereby making it possible to shorten the pre-press process. Of course, the transition of the shape memory resin to the softened state may be started in the first step preceding the second step.
(7) In accordance with one of some aspect, there is provided the electronic component manufacturing method according to the aspect (3), wherein the flat plate material may be a thermoplastic resin, the thermoplastic resin may be in a cured state in the first step and the second step, the thermoplastic resin may enter a softened state by being set at a temperature equal to or more than a glass transition point in the third step and the detachment process, and the thermoplastic resin may enter a cured state in the fourth step and the fifth step.
   The thermoplastic resin offered to a market and easily available can be effectively used as a deformable member in the jig.
(8) In accordance with one of some aspect, there is provided the electronic component manufacturing method according to any one of the aspects (5) to (7), wherein
   the jig may include a base material and a bonding layer forming the bonding surface, and may be arranged with the flat plate material interposed between the base material and the bonding layer, and
   the bonding layer may be deformed to follow the deformation of the flat plate material in the third step.

   Accordingly, the bonding layer is deformed, thereby making it possible to align the respective positions of the end surfaces of the plurality of electronic component bodies to be bonded and held with one another.
(9) In accordance with one of some aspect, there is provided the electronic component manufacturing method according to the aspect (7), wherein
   the thermoplastic resin may be a thermoplastic adhesive.
   If the thermoplastic adhesive is used as the flat plate material, a two-layer structure of the flat plate material and the bonding layer is not required.
(10) In accordance with one of some aspect, there is provided the electronic component manufacturing method according to the aspect (7) or (9), wherein
   in the detachment process, the thermoplastic resin may be softened in a mold material.
   This makes it possible to reliably recover the thermoplastic resin into a reusable shape.
(11) In accordance with one of some aspect, there is provided the electronic component manufacturing method according to any one of the aspects (1) to (10), wherein
   the flat plate material may be set to enter the softened state and the cured state by a temperature adjustment unit disposed in the jig or a base that holds the jig. The temperature adjustment unit may have both a heating unit and a cooling unit, or may be used for both a heating unit and a cooling unit, like a Peltier element, for example. The temperature adjustment unit is disposed in the jig or the base, thereby making it possible to efficiently adjust the temperature of the flat plate material.
(12) In accordance with one of some aspect, there is provided the electronic component manufacturing method according to the aspect (5) or (6), wherein
   the shape memory resin may be set to enter each of respective states of the primary shape and the secondary shape by a temperature adjustment unit disposed in the jig or a base that holds the jig.
   When the temperature adjustment unit is disposed in the jig or the base, the temperature of the shape memory resin can be adjusted such that the shape memory resin is set by switching to have both the primary shape and the secondary shape.
(13) In accordance with one of some aspect, there is provided the electronic component manufacturing method according to any one of the aspects (1) to (10), wherein
   the flat plate material may be set to enter the softened state by a heating unit disposed in the jig or a base that holds the jig, and
   the flat plate material may be set to enter the cured state by a cooling unit disposed in the surface plate.

   The flat plate material can be efficiently heated when the heating unit is disposed in the jig or the base, and the flat plate material can be cooled via the plurality of electronic component bodies when the cooling unit is disposed in the surface plate. Moreover, when the heating unit and the cooling unit are arranged away from each other, an adverse effect of one of the units on the other unit can be reduced.
(14) In accordance with one of some aspect, there is provided the electronic component manufacturing method according to the aspect (5) or (6), wherein
   the shape memory resin may be set to enter the softened state and have the primary shape by a heating unit disposed in the jig or a base that holds the jig, and
   the shape memory resin may be set to enter the cured state by a cooling unit disposed in the surface plate.

The shape memory resin can be efficiently heated and set to enter the softened state or have the primary shape when the heating unit is disposed in the jig or the base, and the shape memory resin can be cooled and cured via the plurality of electronic component bodies when the cooling unit is disposed in the surface plate.

### BRIEF DESCRIPTION OF THE DRAWINGS

FIG. 1A and FIG. 1B are diagrams each illustrating a pre-press process.
FIG. 2A to FIG. 2C are diagrams each illustrating a coating process.
FIG. 3A to FIG. 3C are diagrams each illustrating a process for removing an excess paste.
FIG. 4 is a diagram illustrating a first step in each of first and third embodiments.
FIG. 5 is a diagram illustrating a second step in each of the first and third embodiments.
FIG. 6 is a diagram illustrating third and fourth steps in each of the first and third embodiments.
FIG. 7 is a diagram illustrating a fifth step in each of the first and third embodiments.
FIG. 8 is a diagram illustrating a detachment process in the first embodiment.
FIG. 9A and 9B are diagrams each illustrating a film thickness of a paste layer manufactured in the first embodiment.
FIG. 10 is a diagram illustrating a first step in second embodiment.
FIG. 11 is a diagram illustrating a second step in the second embodiment.
FIG. 12 is a diagram illustrating third and fourth steps in the second embodiment.
FIG. 13 is a diagram illustrating a fifth step in the second embodiment.
FIG. 14 is a diagram illustrating a detachment process in the second embodiment.
FIG. 15 is a diagram illustrating a manufacturing apparatus in which a temperature adjustment unit is disposed in a base material of a jig.
FIG. 16 is a diagram illustrating a manufacturing apparatus in which a temperature adjustment unit is disposed in a base that fixes a jig.
FIG. 17 is a diagram illustrating a manufacturing apparatus in which a heating unit and a cooling unit are respectively disposed in a base material of a jig and a surface plate.
FIG. 18 is a diagram illustrating a manufacturing apparatus in which a heating unit and a cooling unit are respectively disposed in a base that fixes a jig and a surface plate.
FIG. 19 is a diagram illustrating a conventional pre-press method.

### DESCRIPTION OF EMBODIMENTS

In the following disclosure, there are provided many different embodiments and examples for implementing features that differ in presented subject matter. These are, of course, mere examples, and are not intended to be limiting. Further, in the present disclosure, reference numerals and/or characters may be repeated in various examples. Such repetition is for simplicity and clarity, and does not itself require that there is a relationship between the present disclosure and the various embodiments and/or described configurations. Further, when it is described that a first element is "connected" or "coupled" to a second element, such description includes an embodiment in which the first element and the second element are directly connected or coupled to each other, and also includes an embodiment in which the first element and the second element are indirectly connected or coupled to each other with one or more other elements interposed therebetween. When it is described that the first element "moves" with respect to the second element, such description includes an embodiment of movement of at least one of the first element and the second element relative to the other element.

### 1. Electronic Component Manufacturing Method

An electronic component manufacturing method according to the present embodiment includes a pre-press process and a coating process to be performed by holding an electronic component body in a jig, and can include a paste removal process to be performed after the coating process, as needed. After the coating process or the paste removal process, the electronic component body is detached from the jig. The processes will be outlined below.

FIG. 1 to FIG. 3 schematically illustrate main processes in a method for molding an external electrode of a capacitor as an electronic component manufacturing method. A surface plate 30 that can be shared between the pre-press process, the coating process, and the paste removal process of the electronic component body 10 is formed of a ceramic, a granite, or a metal, for example. A squeegee unit 40 is disposed on a surface plate 30. The squeegee unit 40 is movable along a surface 31 of the surface plate 30. The squeegee unit 40 supports a blade 42 made of a metal, for example, which lays a dip layer 50 of a conductive paste at a uniform height, and a blade 44 made of rubber, for example, which scrapes the conductive paste from the surface 31 of the surface plate 30 each independently to be raisable and lowerable.

A movable platen 32 that can be raised and lowered with respect to a fixed platen 34 is arranged above the surface plate 30. A jig 20 is detachably supported on the movable platen 32. Accordingly, the movable platen 32 is also referred to as a base. A lifting motor 36 is supported on the fixed platen 34, and the movable platen 32 is raised and lowered by a screw shaft 38 that is driven to rotate by the lifting motor 36.

### 1.1. Pre-press Process

As illustrated in FIG. 1A, the jig 20 that previously holds a plurality of electronic component bodies 10 is carried into an external electrode formation apparatus. In each of the electronic component bodies 10, a first end portion 12A is a fixed end portion to be held in the jig 20, and a second end portion 12B is a free end. The carried jig 20 is fixed to the movable platen 32. FIG. 1B illustrates a process for adjusting the height of an end surface of the electronic component body 10 (a pre-press process). In FIG. 1B, the electronic component body 10 is lowered by the movable platen 32 relative to the surface plate 30 over which a conductive paste is not laid, to bring an end surface 12B1 of the second end portion 12B of the electronic component body 10 into contact with the surface plate 30. Then, the electronic component body 10 is relatively raised by the movable platen 32. As a result, the height of the end surface 12B1 of the electronic component body 10 becomes uniform.

### 1.2. Coating Process

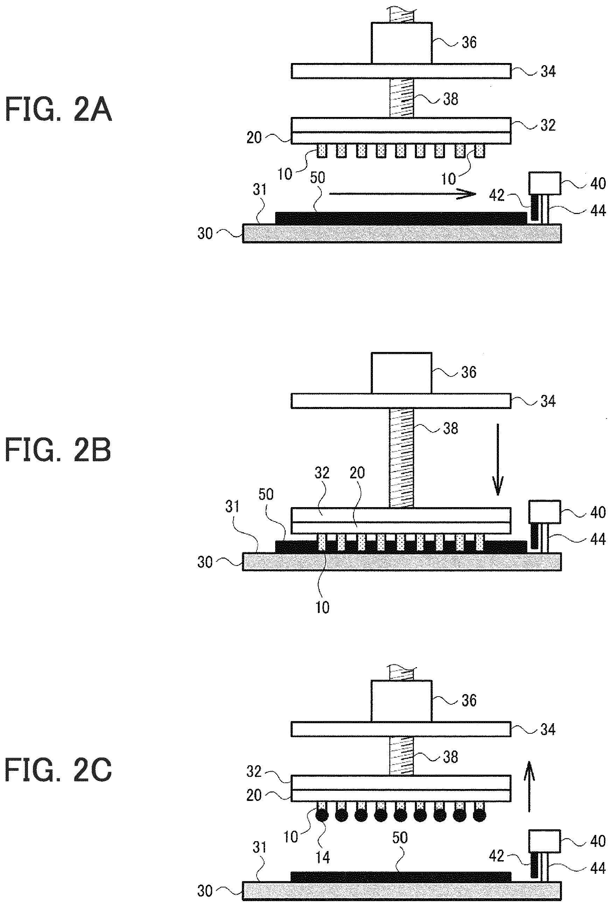

FIG. 2A to FIG. 2C illustrate a coating process for applying the conductive paste. In FIG. 2A, the blade 42 set to have a predetermined height is horizontally moved by the squeegee unit 40, to form the dip layer 50 having a predetermined height of the conductive paste on the surface plate 30. In FIG. 2B, the electronic component body 10 is lowered by the movable platen 32, to dip the second end portion 12B of the electronic component body 10 into the dip layer 50 on the surface plate 30. In this case, the end surface 12B1 of the electronic component body 10 may be or may not be brought into contact with the surface 31 of the surface plate 30. Then, the electronic component body 10 is raised by the movable platen 32. As a result, a conductive paste layer 14 is formed on the second end portion 12B of the electronic component body 10.

### 1.3. Paste Removal Process

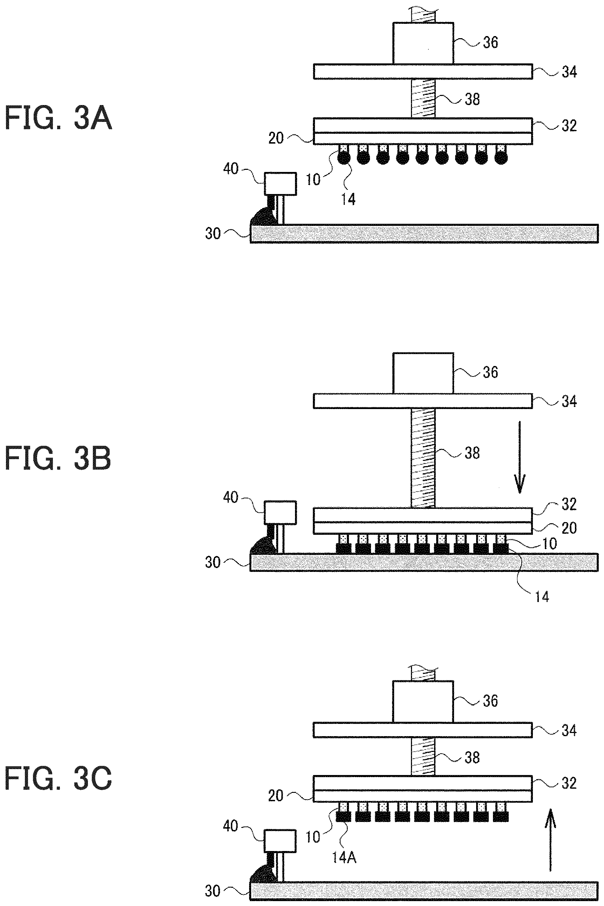

FIG. 3A to FIG. 3C each illustrate a paste removal process (a blotting process). FIG. 3A illustrates a process for horizontally moving the blade 44 lowered to contact the surface 31 of the surface plate 30 by the squeegee unit 40 and scraping the conductive paste on the surface plate 30. In FIG. 3B, the electronic component body 10 is lowered by the movable platen 32, to bring the conductive paste layer 14 formed on the second end portion 12B of the electronic component body 10 into contact with the surface plate 30. Then, the electronic component body 10 is raised by the movable platen 32. As a result, an excess paste in the second end portion 12B of the electronic component body 10 is transferred onto the surface plate 30, to form a flattened conductive paste layer 14A. When the conventional paste removal process illustrated in FIG. 3A to FIG. 3C is replaced with a paste removal process described in JP-B-6633829 (Note: Slide Blot), JP-A-2019-125369 (Note: Helical Blot), or PCT/JP2020/010448, for example, proposed by the present applicant, the conductive paste layer 14A is further improved.

### 2. First Embodiment

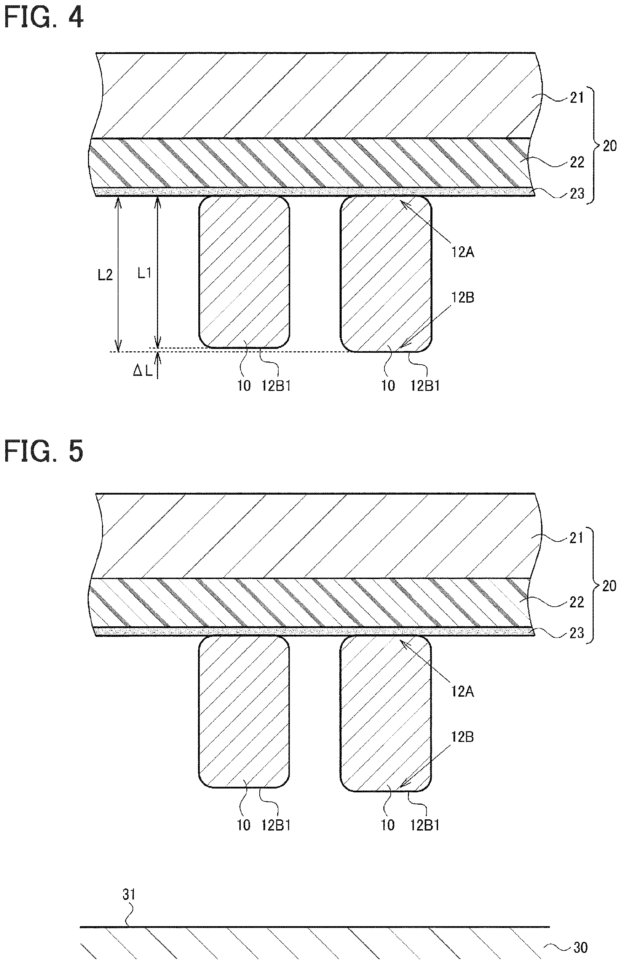

Then, details of a pre-press process and a detachment process according to the first embodiment will be described with reference to FIG. 4 to FIG. 8. In FIG. 4, a jig 20 includes a base material 21 and a flat plate material 22. The base material 21 is a rigid body having shape retentivity, and is detachably supported on a movable platen 32 illustrated in FIG. 1A, for example. The base material 21 also functions as a support portion that supports the flat plate material 22. The base material 21 and the flat plate material 22 are arranged parallel to a surface 31 of a surface plate 30. The flat plate material 22 can be a shape memory resin, for example. If the shape memory resin 22 does not have a bonding function, a bonding layer 23 is formed on an exposed surface of the shape memory resin 22. The bonding layer 23 forms a bonding surface to which a first end portion 12A of an electronic component body 10 is bonded.

The shape memory resin 22 has a two-phase structure including a "stationary phase" in which a shape of a molded product is fixed when the shape memory resin is molded in a mold and a "reversible phase" in which softening and curing reversibly occur with a temperature change. In the present specification, the stationary phase is referred to as a shape memory state, and one state and the other state of the reversible phase are respectively referred to as a softened state and a cured state. A shape in the stationary phase is referred to as a primary shape, and a shape at the time of curing after softening is referred to as a secondary shape. The shape memory resin 22 is molded into the primary shape via a cooling process after a resin supplied in a powder shape or a pellet shape is heated and melted and is injected and shaped into a metal mold or the like. The shape memory resin 22, which has been primarily shaped, is deformed into any shape at an appropriate secondarily shaping temperature, and is fixed in the secondary shape when cooled to room temperature with a stress applied thereto. The shape memory resin 22, which has been secondarily shaped, is recovered to a shape obtained when the shape memory resin 22 is primarily shaped when heated again to an appropriate temperature. The shape memory resin is described in a coloring material 063[6]353-359.1990, for example.

### 2.1. First Step

FIG. 4 illustrates a first step during the pre-press process. In the first step, the first end portion 12A of the electronic component body 10 is bonded to the bonding layer 23 in the jig 20. To collectively bond the plurality of electronic component bodies 10 to the bonding layer 23 in the jig 20, an alignment jig that aligns and holds the plurality of electronic component bodies 10 is used. The shape memory resin 22 used in the present embodiment is a Jmade shape memory plastic (a planar shape retaining type, a flat plane thickness is 0.4 mm, and a shape recovery temperature is 60°C) commercially available. In the first step to be performed with the shape memory resin 22 set at a normal temperature, a shape of the shape memory resin 22 is a primarily shaped flat plate (a shape memory state) having a thickness of 0.4 mm. Lengths of the plurality of electronic component bodes 10 to be held in the jig 20 from the bonding layer 23 to the end surfaces 12B1 may be respectively different lengths L1 and L2, and there may be a variation ΔL (= L2 - L1) thereamong. In this case, respective positions of the end surfaces 12B1 of the two electronic component bodies 10 are not aligned with each other.

### 2.2. Second Step

FIG. 5 illustrates a second step during the pre-press process. In the second step, the jig 20 is moved relative to the surface plate 30. In FIG. 5, the jig 20 is lowered with respect to the fixed surface plate 30. In the second step, a shape of the shape memory resin 22 is also a primarily shaped flat plate (a shape memory state) having a thickness of 0.4 mm.

### 2.3. Third Step and Fourth Step

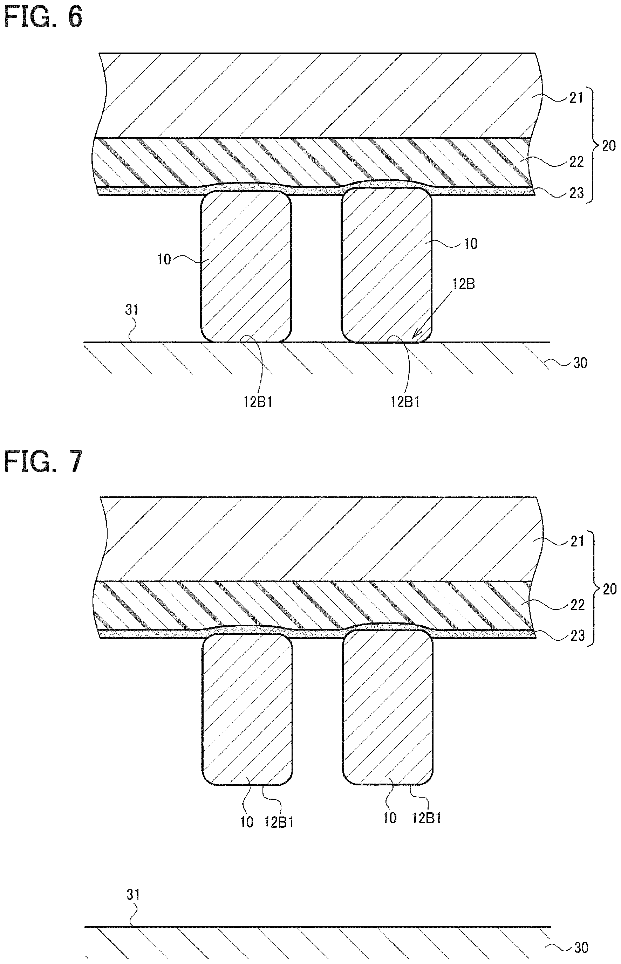

FIG. 6 illustrates a third step and a fourth step during the pre-press process. In the third step, the shape memory resin 22 is brought into a softened state by being heated to 70 to 120°C, for example, higher than a glass transition point, and the second end portion 12B of the electronic component body 10 is brought into contact with the surface plate 30 over a predetermined time period. The softening temperature can be the glass transition point or more and less than a melting point. As a result, the shape memory resin 22 and the bonding layer 23 are deformed by pressurization. A shape of the shape memory resin 22 is a secondary shape. Forced heating of the shape memory resin 22 may be started during the second step. In the fourth step, the shape memory resin 22 is brought into a cured state by being forcedly cooled, for example, within a range from less than the glass transition point to a normal temperature with the second end portion 12B of the electronic component body 10 brought into contact with the surface plate 30. The shape memory resin 22 is cured while remaining in the secondary shape. When the third step and the fourth step are performed, the position of the end surface 12B 1 of the second end portion 12B of the electronic component body 10 can be aligned to be flush with the surface of the surface plate 30.

### 2.4. Fifth Step

FIG. 7 illustrates a fifth step during the pre-press process. In the fifth step, the jig 20 is moved relative to the surface plate 30, and the electronic component body 10 in which the respective positions of the end surfaces 12B1 are aligned with one another is separated from the surface plate 30. As a result, the pre-press process is completed. In FIG. 7, the jig 20 is raised with respect to the fixed surface plate 30. The fifth step can be performed with the shape memory resin 22 secondarily shaped set at a normal temperature.

### 2.5. Detachment Process

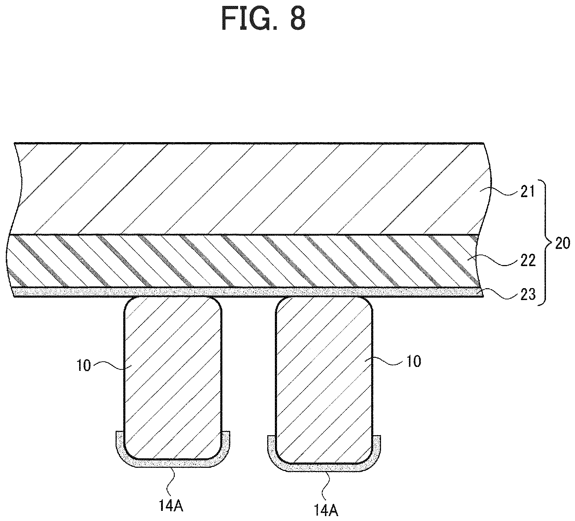

After completion of the pre-press process, the above-described coating process and the paste removal process, if necessary, are performed. In any case, when processing for the electronic component body 10 held in the jig 20 is completed, the electronic component body 10 is detached from the jig 20. Accordingly, in a detachment process, the shape memory resin 22 is deformed into a state where the electronic component body 10 can be detached from the jig 20 and a shape retained state other than a shape (a secondary shape) in a softened state and a cured state. The shape memory resin 22 can be recovered to a primary shape as a shape retained state other than the secondary shape. The shape memory resin 22 is formed into a flat plate, as illustrated in FIG. 8, when recovered from a secondary shape to a primary shape by being heated again to a shape recovery temperature, e.g., 60°C or more. As a result, the bonding layer 23 is also flattened, thereby making it possible to easily detach the electronic component body 10 from the bonding layer 23.

### 2.6. Evaluation

The film thickness of the paste layer 14A formed on the second end portion 12B of the electronic component body 10 manufactured using the manufacturing method according to the first embodiment was evaluated. As the paste removal process to be performed after the coating process, the blotting process disclosed in JP-B-6633829 proposed by the present applicant was used.

In the evaluation, two pairs of electronic component bodies 10, the pair having a standard length of 603 mm respectively corresponding to two types of lengths L1 and L2 illustrated in FIG.4, were prepared, to evaluate a variation in film thickness of a paste layer 14A for each of the pairs. For electronic component bodies 10 respectively having two types of lengths, the film thickness of the paste layer 14A formed using the manufacturing method according to the first embodiment (an example) and the film thickness of the paste layer 14A formed without using the manufacturing method according to the first embodiment (a comparative example) were compared with each other. In the comparative example, heating and cooling of the shape memory resin 22 were stopped in the third and fourth steps in the pre-press process in the first embodiment. The electronic component body 10 having the length L1 illustrated in FIG.4 was set as a comparative example 1 or an example 1. The electronic component body 10 having the length L2 illustrated in FIG.4 is set as a comparative example 2 or an example 2. In the comparative examples 1 and 2 as a pair of comparison targets, a variation ΔL between the respective lengths L1 and L2 of the electronic component bodies 10 illustrated in FIG.4 is also reflected on the paste layers 14A. To set the respective lengths L1 and L2, between which there is a large variation ΔL, of the electronic component bodies 10 as a pair of evaluation targets, products respectively manufactured by different manufacturers were set as the pair of evaluation targets.

A variation in film thickness of the paste layer 14A was 39 to 88 µm between the comparative examples 1 and 2 while being 2 to 18 µm between the examples 1 and 2. That is, it has been found that even when the variation ΔL between the lengths L1 and L2 of the electronic component bodies 10 illustrated in FIG.4 is 39 to 88 µm, the variation in film thickness of the paste layer 14A is suppressed to 2 to 18 µm using the method according to the first embodiment.

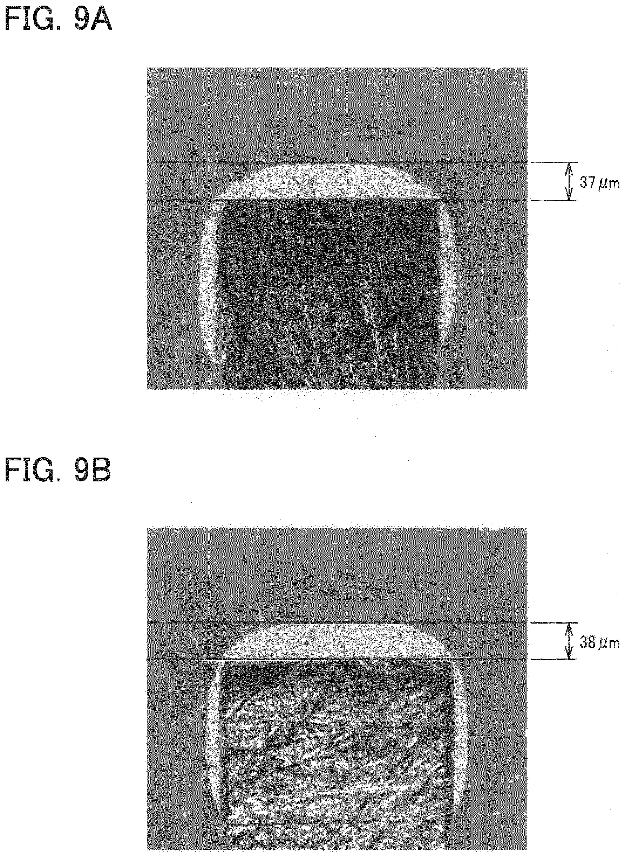

While the maximum film thickness of the paste layer 14A in the comparative example 1 corresponding to the length L1 illustrated in FIG.4 was 79 µm as an example, the maximum film thickness of the paste layer 14A was 37 µm, as illustrated in FIG. 9A, in the example 1. While the maximum film thickness of the paste layer 14A in the comparative example 2 corresponding to the length L2 illustrated in FIG.4 was 24 µm, the maximum film thickness of the paste layer 14A was 38 µm, as illustrated in FIG. 9B, in the example 2. While a variation of the paste layer 14A between the pair of comparative examples 1 and 2 was 55 µm (79 - 24), a variation of the paste layer 14A between the pair of examples 1 and 2 was set to only 1 µm (38 - 37).

The above-described evaluation relates to the paste layer 14A formed on the second end portion 12B of the electronic component body 10 illustrated in FIG.4. The electronic component body 10 in which the paste layer 14A is formed on the second end portion 12B is detached from the jig 20 by the above-described detachment process. Then, the second end portion 12B on which the paste layer 14A is formed is held in the jig 20 so that the paste layer 14A is similarly formed on the first end portion 12A of the electronic component body 10.

The paste layer 14A formed on the first end portion 12A of the electronic component body 10 illustrated in FIG.4 was also evaluated. In the case, as the film thickness of the paste layer 14A formed on the second end portion 12B of the electronic component body 10 in the example 1 corresponding to the length L1 illustrated in FIG.4 out of evaluation targets manufactured using the method according to the first embodiment, a film thickness in a range of 32 to 40 µm was selected. The film thickness of the paste layer 14A formed using the method according to the first embodiment on the first end portion 12A of the electronic component body 10 in the example 1 was 32 to 45 µm. That is, a variation in film thickness of the paste layer 14A formed on the second end portion 12B was 8 µm (40 - 32), a variation in film thickness of the paste layer 14A formed on the first end portion 12A was 13 µm (45 - 32), and the variations in film thickness of the paste layers 14A respectively formed on both the end portions 12A and 12B were approximately the same.

Then, as the film thickness of the paste layer 14A formed on the second end portion 12B of the electronic component body 10 in the example 2 corresponding to the length L2 illustrated in FIG.4, a film thickness in a range of 31 to 38 µm was selected. The film thickness of the paste layer 14A formed using the method according to the first embodiment on the first end portion 12A of the electronic component body 10 in the example 2 was 35 to 40 µm. That is, a variation in film thickness of the paste layer 14A formed on the second end portion 12B was 7 µm (38 - 31), a variation in film thickness of the paste layer 14A formed on the first end portion 12A was 5 µm (40 - 35), and the variations in film thickness of the paste layers 14A respectively formed on both the end portions 12A and 12B were approximately the same.

From the foregoing evaluation result, according to the first embodiment, it has been found that the degree of reflection of the variation ΔL between the lengths L1 and L2 of the plurality of electronic component bodies 10 illustrated in FIG.4 on a difference in film thickness between the paste layers 14A respectively formed on the first and second end portions 12A and 12B of the plurality of electronic component bodies 10 can be reduced. This makes it possible to significantly reduce the difference in film thickness between the respective paste layers 14A in the plurality of electronic component bodies 10.

### 3. Second Embodiment

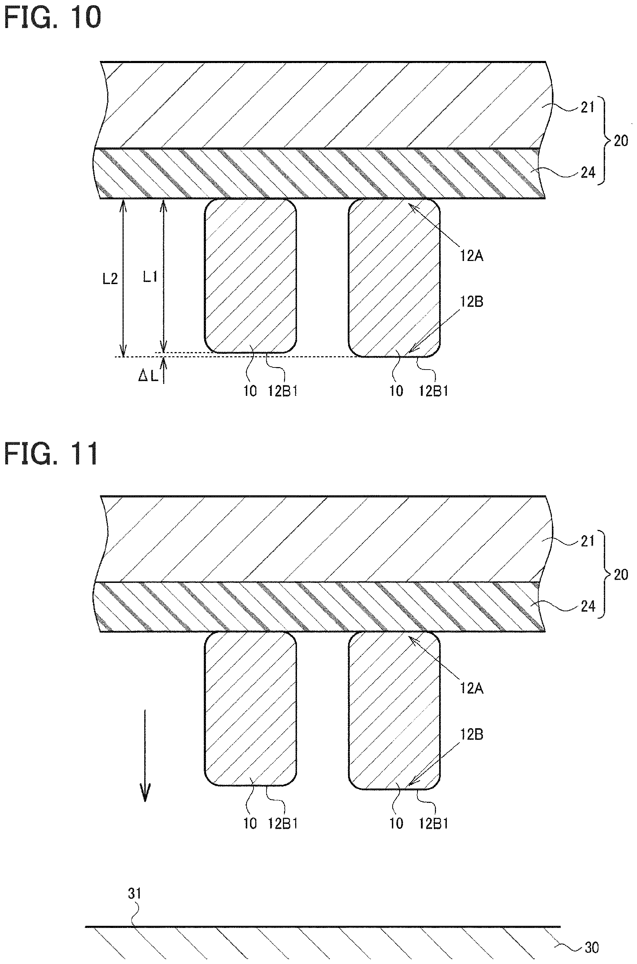

Then, details of a pre-press process and a detachment process according to a second embodiment will be described with reference to FIG. 10 to FIG. 14. In FIG. 10, a jig 20 includes a base material 21 and a flat plate material 24. The flat plate material 24 can be a thermoplastic resin, for example. The thermoplastic resin 24 can be a thermoplastic adhesive. Accordingly, the bonding layer 23 is not required, although illustrated in FIG. 4. An exposed surface of the thermoplastic adhesive 24 forms a bonding surface to which a first end portion 12A of an electronic component body 10 is bonded.

The thermoplastic adhesive 24 has a "reversible phase" in which softening and curing reversibly occur with a temperature change. The thermoplastic adhesive 24 is deformed into any shape at a temperature equal to or more than a glass transition point, and is cured when cooled with a stress applied thereto. An example of the thermoplastic adhesive 24 favorably usable is a hot melt adhesive such as a thermoplastic polyester-based hot melt adhesive that has its main component melting and applying a solid adhesive of a thermoplastic resin and is solidified when cooled to exhibit an adhesive strength.

### 3.1. First Step

FIG. 10 illustrates a first step during a pre-press process. In the first step, the first end portion 12A of the electronic component body 10 is bonded to the thermoplastic adhesive 24 in the jig 20. The thermoplastic adhesive 24 used in the first step is at a normal temperature and is solidified by a flat plate. Respective lengths of a plurality of electronic component bodes 10 to be held in the jig 20 from a bonding layer 23 to end surfaces 12B1 may be respectively different lengths L1 and L2, and there may be a variation ΔL = (L2 - L1) thereamong. In this case, respective positions of the end surfaces 12B1 of the two electronic component bodies 10 are not aligned with each other.

### 3.2. Second Step

FIG. 11 illustrates a second step during the pre-press process. In the second step, the jig 20 is moved relative to a surface plate 30. In FIG. 5, the jig 20 is lowered with respect to the fixed surface plate 30. In the second step, the thermoplastic adhesive 24 is also at a normal temperature and solidified by a flat plate.

### 3.3. Third Step and Fourth Step

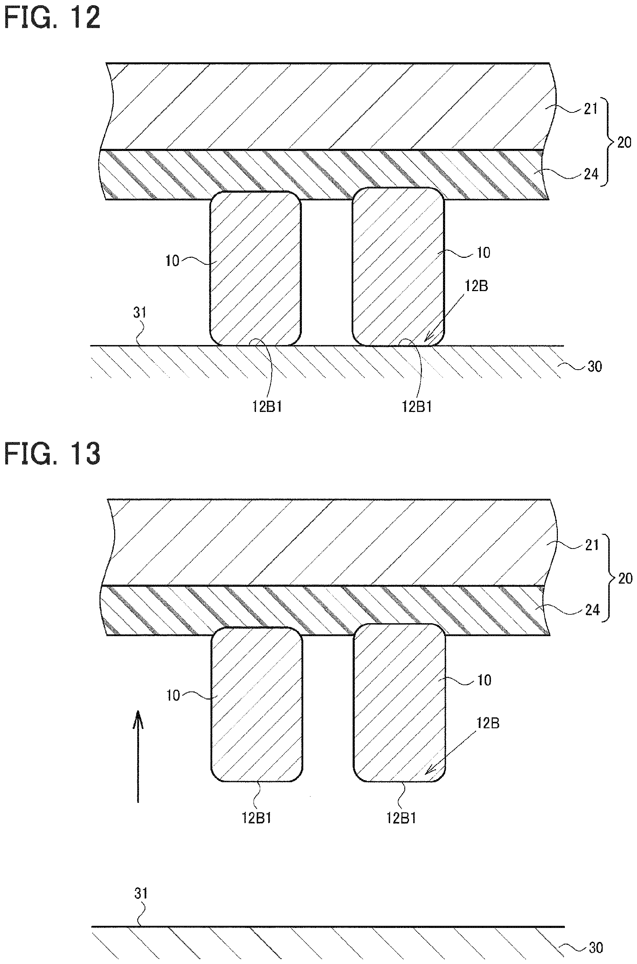

FIG. 12 illustrates a third step and a fourth step during the pre-press process. In the third step, the thermoplastic adhesive 24 is brought into a softened state by being heated to a temperature equal to or more than a glass transition point, and a second end portion 12B of the electronic component body 10 is brought into contact with the surface plate 30. As a result, the thermoplastic adhesive 24 is deformed under pressure. In the fourth step, the thermoplastic adhesive 24 is brought into a cured state by being forcedly cooled, for example, to a normal temperature less than the glass transition point with the second end portion 12B of the electronic component body 10 brought into contact with the surface plate 30. The thermoplastic adhesive 24 is cured while remaining in a shape given in the third step. When the third step and the fourth step are performed, a position of the end surface 12B1 of the second end portion 12B of the electronic component body 10 can be aligned to be flush with a surface of the surface plate 30.

### 3.4. Fifth Step

FIG. 13 illustrates a fifth step during the pre-press process. In the fifth step, the jig 20 is moved relative to the surface plate 30, and the electronic component bodies 10 in which the respective positions of the end surfaces 12B1 are aligned with one another are separated from the surface plate 30. As a result, the pre-press process is completed. In FIG. 7, the jig 20 is raised with respect to the fixed surface plate 30. The fifth step can be performed with a shape of the thermoplastic adhesive 24 deformed in the third step and the fourth step maintained under the normal temperature.

### 3.5. Detachment process

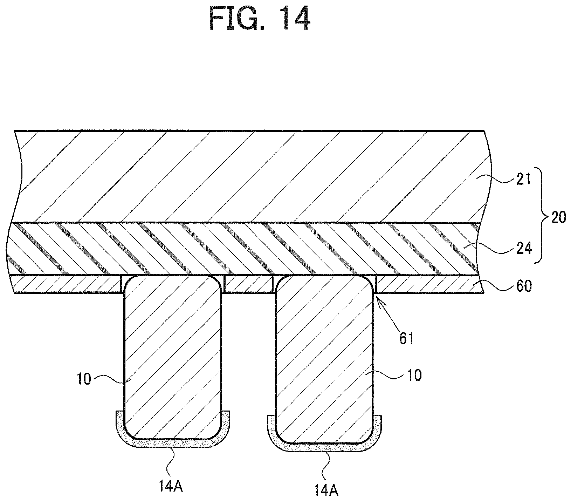

In a detachment process, the thermoplastic adhesive 24 is softened to make the electronic component body 10 detachable from the jig 20. Accordingly, the thermoplastic adhesive 24 is heated to a temperature equal to or more than the glass transition point. In the case, to prevent unexpected deformation of the thermoplastic adhesive 24, a mold material 60 can be used, as illustrated in FIG. 14. The mold material 60 can cover an exposed surface of the thermoplastic resin 24 and particularly a lower surface of the thermoplastic adhesive 24 illustrated in FIG. 14. The mold material 60 has a hole 61 that prevents interference with the electronic component body 10. The thermoplastic adhesive 24 to be softened in the mold material 60 is recovered to an original flat plate from a shape given in the third step and the fourth step. As a result, the electronic component body 10 can be easily detached from the flattened thermoplastic adhesive 24.

### 4. Third Embodiment

In a third embodiment, a thermoplastic resin 25 that is not a thermoplastic adhesive 24 is used as a flat plate material in a jig 20. FIG. 4 to FIG. 9 illustrate a thermoplastic resin 25 arranged between a base material 21 and a bonding layer 23 instead of a shape memory resin 22 in the first embodiment. Therefore, if the shape memory resin 22 in the first embodiment is changed into the thermoplastic resin 25, a phase of the thermoplastic resin 25 is changed, like in the second embodiment, in a first step to a fifth step so that a pre-press process can be performed.

A detachment process can be performed by arranging the mold material 60 illustrated in FIG. 14 to cover the bonding layer 23 illustrated in FIG. 9. Alternatively, the mold material 60 need not be arranged, but the bonding layer 23 may function as the mold material 60.

### 5. Fourth Embodiment

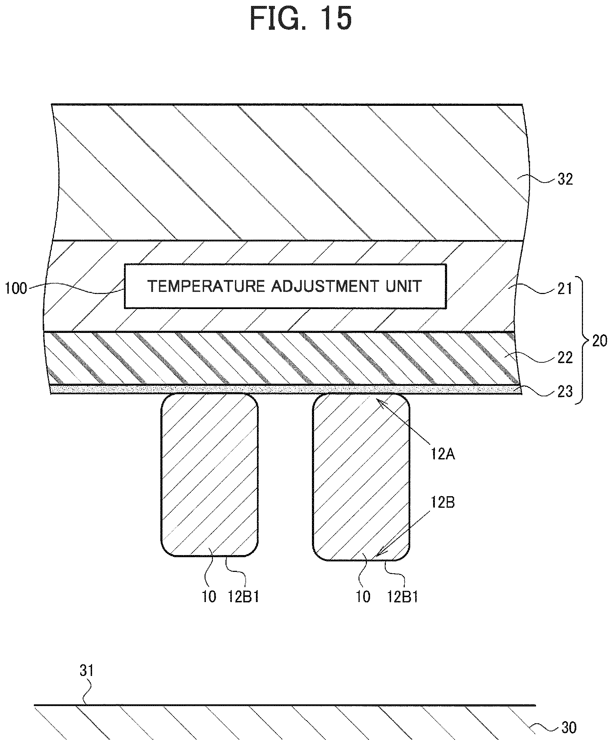

Then, a temperature adjustment unit in a flat plate material 22, 24, or 25 in a jig 20 will be described. FIG. 15 to FIG. 18 describe the temperature adjustment unit for the first embodiment, but are also similarly applicable to the second embodiment and the third embodiment.

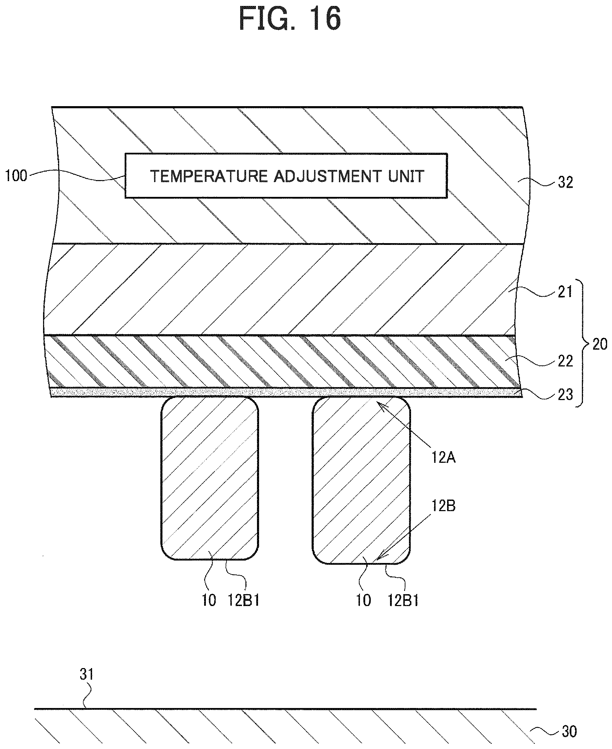

In FIG. 15, a temperature adjustment unit 100 is disposed in a base material 21 in a jig 20. The temperature adjustment unit 100 may have both a heating unit and a cooling unit, or may be shared between a heating unit and a cooling unit, like a Peltier element, for example. As a result, the temperature adjustment unit 100 can efficiently heat or cool a shape memory resin 22 via the base material 21 that can be formed of a material having a high conductivity, for example, a metal. In FIG. 16, a temperature adjustment unit 100 is disposed in a base 32 to which a jig 20 is fixed. As a result, the temperature adjustment unit 100 can efficiently heat and cool a shape memory resin 22 via the base 32 and a base material 21 that can be formed of a material having a high conductivity, for example, a metal. Thus, when the temperature adjustment unit 100 is disposed in the jig 20 or the base 32, the temperature of the shape memory resin 22 can be adjusted such that the shape memory resin 22 is set by switching to have both a primary shape and a secondary shape.

In the second and third embodiments, the temperature adjustment unit 100 disposed in the jig 20 or the base 32 can set the thermoplastic resins (thermoplastic adhesives) 24 and 25 to enter a softened state and a cured state.

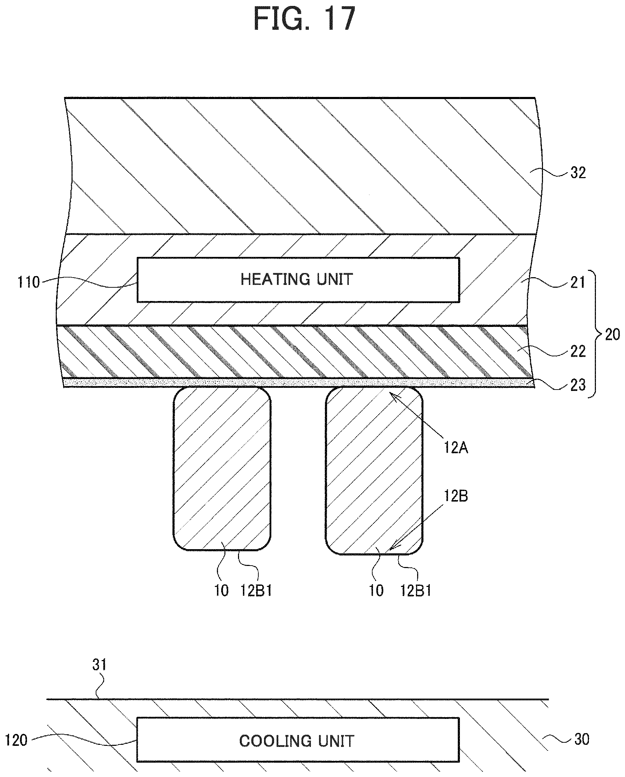

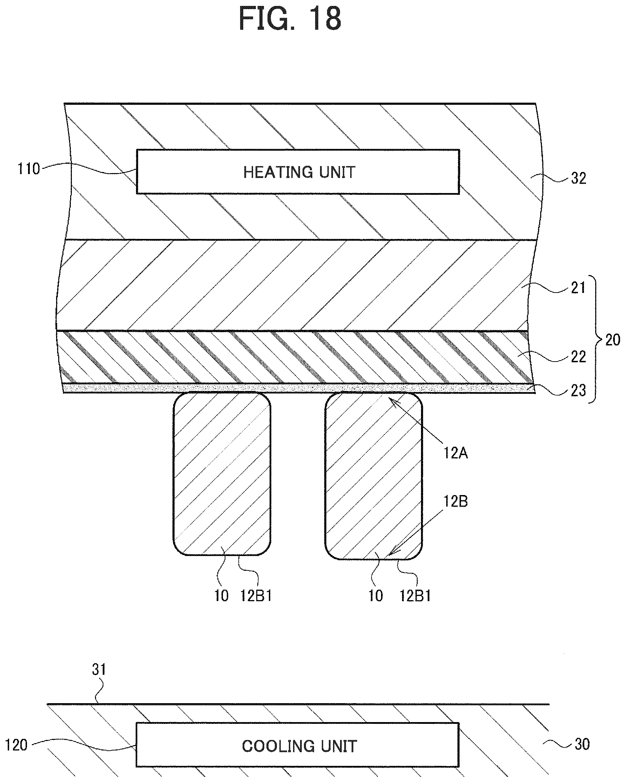

In FIG. 17, a heating unit 110 and a cooling unit 120 are respectively disposed in a base material 21 of a jig 20 and a surface plate 30. In FIG. 18, a heating unit 110 and a cooling unit 120 are respectively disposed in a base 32 that fixes a jig 20 and a surface plate 30. By the heating unit 110 disposed in the jig 20 or the base 32, a shape memory resin 22 is set to enter a softened state and a shape memory state. By the cooling unit 120 disposed in the surface plate 30, the shape memory resin 22 is cooled via a plurality of electronic component bodies 10 and is set to enter a cured state. Moreover, when the heating unit 110 and the cooling unit 120 are arranged away from each other, an adverse effect of one of the units on the other unit can be reduced.

In the second and third embodiments, by the heating unit 110 disposed in the jig 20 or the base 32, the thermoplastic resins (thermoplastic adhesives) 24 and 25 can be each set to enter a softened state. By the cooling unit 120 disposed in the surface plate 30, the shape memory resin 22 is cooled via the plurality of electronic component bodies 10 and is set to enter a cured state.

Although the embodiments have been described in detail above, it will be readily appreciated by those skilled in the art that many modifications that do not materially depart from a new matter and an effect of the invention are possible. Therefore, all such modifications are intended to be included in the scope of the invention.

For example, a thermosetting resin and a softenable and curable stimulus responsive material, for example, can be used in addition to a shape memory resin or a thermoplastic resin (a thermoplastic adhesive) as a flat plate material that changes into a softened phase and a cured phase. The stimulus responsive resin is described in Journal of the Japan Society of Mechanical Engineers, Vol. 107, No. 1032, 2004. 11, for example. Although the stimulus responsive material is a gel, a resin, or an elastomer, for example, the property of which changes depending on a physical stimulus (a temperature, light, a magnetic field, a current), a stimulus responsive material that is reversibly softened and cured by a physical stimulus has been reported in recent years from National Institute of Advanced Industrial Science and Technology, Hokkaido University, University of Tsukuba, Yamagata University, Keio University, and the like. Therefore, a stimulus responsive resin that is reversibly softened and cured may be used as a flat plate material. In this case, the temperature adjustment unit 100, the heating unit 110, and the cooling unit 120 illustrated in FIG. 15 to FIG. 18 are respectively changed into physical stimulus units.

### REFERENCE SIGNS LIST

- 10: electronic component body
- 12A: first end portion
- 12B: second end portion
- 12B1: end surface
- 14, 14A: paste layer
- 20: jig
- 21: base material
- 22: flat plate material (shape memory resin)
- 23: bonding layer
- 24: flat plate material (thermoplastic adhesive)
- 25: flat plate material (thermoplastic resin)
- 30: surface plate
- 32: base (movable platen)
- 50: mold material
- 100: temperature adjustment unit
- 110: heating unit
- 120: cooling unit

## Claims

1. An electronic component manufacturing method comprising a coating process for coating each of a plurality of electronic component bodies with a paste and a pre-press process to be performed before the coating process, wherein
the pre-press process comprises:
a first step for bonding a first end portion of each of the plurality of electronic component bodies to a bonding surface on an exposed surface of a flat plate material disposed in a jig;
a second step for moving the jig relative to a surface plate;
a third step for bringing the flat plate material into a softened state and bringing a second end portion on the opposite side to the first end portion of each of the plurality of electronic component bodies into contact with the surface plate so that the flat plate material is deformed to align respective positions of end surfaces of the second end portions;
a fourth step for bringing the flat plate material into a cured state with the respective positions of the end surfaces aligned with one another; and then
a fifth step for moving the jig relative to the surface plate, and separating, from the surface plate, the plurality of electronic component bodies in which the positions of the end surfaces are aligned with one another.

2. The electronic component manufacturing method according to claim 1, further comprising
a paste removal process for removing an excess paste from the paste applied to the second end portion of each of the plurality of electronic component bodies held in the jig to form a paste layer after the coating process.

3. The electronic component manufacturing method according to claim 1 or 2, further comprising
a detachment process for detaching the plurality of electronic component bodies from the jig after the coating process or the paste removal process,
wherein, in the detachment process, the flat plate material deformed in the third step and cured in the fourth step is softened again to make the plurality of electronic component bodies detachable from the jig.

4. The electronic component manufacturing method according to claim 1 or 2, further comprising
a detachment process for detaching the plurality of electronic component bodies from the jig after the coating process or the paste removal process,
wherein, in the detachment process, the flat plate material deformed in the third step and cured in the fourth step is deformed into a state where the plurality of electronic component bodies can be detached from the jig and a shape retained state other than the softened state and the cured state.

5. The electronic component manufacturing method according to claim 4, wherein
the flat plate material is a shape memory resin, the shape memory resin is set to have a flat plate shape as a shape-memory primary shape in the first step, the second step, and the detachment process, and the shape memory resin is set to have any secondary shape equal to the softened state or the cured state where the respective positions of the end surfaces of the second end portions are aligned with one another in the third step, the fourth step, and the fifth step.

6. The electronic component manufacturing method according to claim 5, wherein
transition of the shape memory resin to the softened state is started in the second step.

7. The electronic component manufacturing method according to claim 3, wherein
the flat plate material is a thermoplastic resin, the thermoplastic resin is in a cured state in the first step and the second step, the thermoplastic resin enters a softened state by being set at a temperature equal to or more than a glass transition point in the third step and the detachment process, and the thermoplastic resin enters a cured state in the fourth step and the fifth step.

8. The electronic component manufacturing method according to any one of claims 5 to 7, wherein
the jig includes a base material and a bonding layer forming the bonding surface, and is arranged with the flat plate material interposed between the base material and the bonding layer, and
the bonding layer is deformed to follow the deformation of the flat plate material in the third step.

9. The electronic component manufacturing method according to claim 7, wherein
the thermoplastic resin is a thermoplastic adhesive.

10. The electronic component manufacturing method according to claim 7 or 9, wherein
in the detachment process, the thermoplastic resin is softened in a mold material.

11. The electronic component manufacturing method according to any one of claims 1 to 10, wherein
the flat plate material is set to enter the softened state and the cured state by a temperature adjustment unit disposed in the jig or a base that holds the jig.

12. The electronic component manufacturing method according to claim 5 or 6, wherein
the shape memory resin is set to enter each of respective states of the primary shape and the secondary shape by a temperature adjustment unit disposed in the jig or a base that holds the jig.

13. The electronic component manufacturing method according to any one of claims 1 to 10, wherein
the flat plate material is set to enter the softened state by a heating unit disposed in the jig or a base that holds the jig, and
the flat plate material is set to enter the cured state by a cooling unit disposed in the surface plate.

14. The electronic component manufacturing method according to claim 5 or 6, wherein
the shape memory resin is set to enter the softened state and have the primary shape by a heating unit disposed in the jig or a base that holds the jig, and
the shape memory resin is set to enter the cured state by a cooling unit disposed in the surface plate.
